(19) Europäisches Patentamt

European Patent Office

Office européen des brevets

(11) **EP 1 717 915 B1**

(12) **FASCICULE DE BREVET EUROPEEN**

(45) Date de publication et mention
de la délivrance du brevet:
**16.01.2008 Bulletin 2008/03**

(51) Int Cl.:
***H01S 3/0941*** *(2006.01)*

(21) Numéro de dépôt: **06290483.4**

(22) Date de dépôt: **27.03.2006**

(54) **Système de pompage optique pour source laser et source laser comportant un tel système de pompage optique**

System zum optischen Pumpen einer Laserquelle und Laserquelle welche dieses optische Pumpsystem verwendet

Optical pump system for a laser source, and laser source comprising such an optical pump system

(84) Etats contractants désignés:
**DE GB IT SE**

(30) Priorité: **25.04.2005 FR 0504110**

(43) Date de publication de la demande:
**02.11.2006 Bulletin 2006/44**

(73) Titulaire: **COMPAGNIE INDUSTRIELLE DES
LASERS CILAS
45100 Orléans (FR)**

(72) Inventeurs:
• **Montagne, Jean-Eucher
45000 Orléans (FR)**
• **Le Neve, Marc
45000 Orléans (FR)**

(74) Mandataire: **Bonnetat, Christian
CABINET BONNETAT
29, rue de St. Pétersbourg
75008 Paris (FR)**

(56) Documents cités:
**FR-A- 2 803 697          US-A1- 2005 018 743
US-B1- 6 760 151**

**Description**

La présente invention concerne un système de pompage pour source laser, ainsi qu'une source laser comportant un tel système de pompage.

Plus précisément, ladite source laser est du type connu comportant :

- un élément actif comportant une matrice dopée susceptible d'absorber un faisceau de pompage pour amplifier au moins un rayonnement laser;
- un système de pompage, comportant des diodes laser de pompage susceptibles d'émettre un faisceau de pompage pénétrant dans ledit barreau ;
- un système optique de transport pour diriger le faisceau de pompage émis par ledit système de pompage dans ledit élément actif de manière à obtenir le pompage dudit élément actif ; et
- une cavité optique permettant d'extraire ledit rayonnement laser.

Dans cette source laser à laquelle se rapporte la présente invention, le pompage peut, par rapport audit élément actif, être longitudinal, transversal, semi-transversal ou autre.

On sait que pour être efficace, le faisceau de pompage doit être spectralement accordé au spectre d'absorption de l'élément actif de telle sorte que ledit faisceau de pompage soit absorbé et transfère son énergie vers l'ion de terre rare dopant ledit élément actif.

On sait également que les diodes laser de pompage présentent un spectre d'émission, généralement de quelques nanomètres de large, qui se décale de 0,25 à 0,3 nanomètre par degré, lorsque l'on fait varier la température desdites diodes de pompage.

Pour assurer une conformité satisfaisante de la longueur d'onde du faisceau de pompage (issu des diodes laser de pompage) avec le spectre d'absorption du milieu actif, il est connu de monter lesdites diodes laser sur des modules Peltier, dont la fonction est de stabiliser leur température avec une précision meilleure que 0,5°C de sorte qu'un centrage de longueur d'onde est assuré à au moins 0,2 nm.

Toutefois, notamment dans le cadre d'applications militaires, les paramètres de compacité, de consommation et de rapidité de mise en oeuvre revêtent une importance particulière. Aussi, l'utilisation de modules Peltier, qui induit une consommation importante et qui nécessite un temps de stabilisation de l'ordre de la minute, est un frein à l'emploi de sources laser pompées par diode(s) laser dans des systèmes compacts. Il en va de même pour d'autres systèmes de stabilisation actifs de la température des diodes. Aussi, la technologie toujours employée actuellement, par exemple pour des désignateurs laser terrestres, est une technologie de pompage par lampe flash, qui est peu efficace et de plus encombrante.

Pour essayer de remédier à ce problème, il convient :

- soit d'augmenter la tolérance du milieu actif à la dérive de longueur d'onde, ce qui est proposé par exemple par le brevet FR-2 803 697, pour lequel le faisceau de pompage est guidé de façon à passer plusieurs fois au travers du milieu actif ;
- soit de mettre en oeuvre une stabilisation passive de l'émission de la longueur d'onde des diodes de pompage, comme proposé par exemple dans la demande de brevet US-2005/0018743 qui décrit l'utilisation d'un système incluant un ou plusieurs Réseaux de Bragg en Volume (RBV ou VBG, pour "Volume Bragg Grating" en anglais) afin de conditionner une ou plusieurs des caractéristiques d'émission du laser.

Toutefois, les solutions précédentes permettent uniquement d'obtenir une insensibilité sur 3 à 10 nanomètres correspondant à une dérive de température des diodes de 15 à 40°C. Une telle plage d'insensibilité thermique est largement insuffisante pour utiliser le système de pompage, par exemple dans un désignateur laser terrestre, entre -40°C et 70°C.

La présente invention a pour objet de remédier à ces inconvénients. Elle concerne un système de pompage pour source laser, permettant d'obtenir un faisceau de pompage présentant une plage d'insensibilité thermique extrêmement étendue, par exemple entre -40°C et +70°C.

A cet effet, selon l'invention, définie dans la revendication 1, ledit système de pompage pour source laser, du type comportant :

- au moins une diode laser de pompage susceptible d'émettre au moins un faisceau de pompage, dont la longueur d'onde varie avec la température ;
- au moins un moyen de collimation associé à ladite diode de pompage ; et
- au moins un miroir sélectif permettant de sélectionner une longueur d'onde de ladite diode de pompage,

est remarquable en ce que ledit miroir sélectif est formé de manière à comprendre une pluralité de pics de réflectivité spectrale pour accrocher le fonctionnement de ladite diode laser de pompage à chaque fois sur au moins l'un de ces pics lors d'une variation de température de ladite diode laser de pompage de sorte que le système de pompage émette un faisceau de pompage dont la longueur d'onde varie par palier, successivement suivant une pluralité de longueurs d'onde prédéterminées, lors de ladite variation de température.

De préférence, lesdites longueurs d'onde prédéterminées correspondent à des longueurs d'onde, pour lesquelles un coefficient d'absorption d'un élément actif pour source laser (qui est associé audit système de pompage) est supérieur à chaque fois à une valeur prédéterminée (élevée), par exemple 1,7 cm$^{-1}$, c'est-à-dire pour lesquelles on obtient une absorption importante du faisceau de pompage par l'élément actif associé de la source laser.

Ainsi, grâce aux caractéristiques conformes à l'invention dudit miroir sélectif, lorsque la température varie, la longueur d'onde du faisceau de pompage émis par le système de pompage ne varie pas (proportionnellement) de façon continue, mais elle varie par paliers en prenant à chaque fois une ou plusieurs valeurs (de longueur d'onde) qui permettent une bonne absorption dudit faisceau de pompage par l'élément actif, rendant ainsi le pompage particulièrement efficace. On obtient donc un faisceau de pompage présentant une plage d'insensibilité thermique particulièrement étendue.

De façon avantageuse, ledit miroir sélectif est formé de sorte que lesdites longueurs d'onde prédéterminées correspondent à des longueurs d'onde pour lesquelles ledit coefficient d'absorption optique fait partie à chaque fois d'un même domaine de coefficients d'absorption, relativement limité, par exemple [1,7 cm$^{-1}$ ; 2,2 cm$^{-1}$]. Grâce à cette caractéristique, on obtient un pompage relativement uniforme dans le milieu actif, quelle que soit la température.

Dans le cadre de la présente invention, ledit miroir sélectif peut être réalisé de différentes manières. En particulier :

- il peut comporter des réseaux de Bragg formés dans au moins un milieu solide ; ou
- il peut comporter des dépôts multi-diélectriques réalisés sur des substrats ; ou
- il peut être réalisé de manière à engendrer un effet Fabry-Pérot, reposant sur le principe des interférences entre deux surfaces réfléchissantes.

La présente invention concerne également une source laser, telles que définie dans la revendication 6, du type comportant :

- un élément actif qui comporte une matrice dopée susceptible d'absorber au moins un faisceau de pompage pour amplifier au moins un rayonnement laser ;
- un système de pompage susceptible d'émettre au moins un faisceau de pompage ;
- un système optique de transport pour diriger le faisceau de pompage émis par ledit système de pompage dans ledit élément actif de manière à obtenir le pompage dudit élément actif ; et
- une cavité optique permettant ainsi d'extraire ledit rayonnement laser.

Selon l'invention, ladite source laser est remarquable en ce que ledit système de pompage est du type de celui précité.

Les figures du dessin annexé feront bien comprendre comment l'invention peut être réalisée. Sur ces figures, des références identiques désignent des éléments semblables.

La figure 1 est le schéma synoptique d'un exemple de réalisation d'une source laser conforme à l'invention.

Les figures 2 et 3 sont des vues schématiques, respectivement de dessus et de côté, d'un système de pompage conforme à l'invention.

Les figures 4 à 6 sont des graphiques permettant d'expliquer des caractéristiques essentielles de la présente invention.

La figure 7 montre schématiquement un mode de réalisation particulier d'un système de pompage conforme à l'invention.

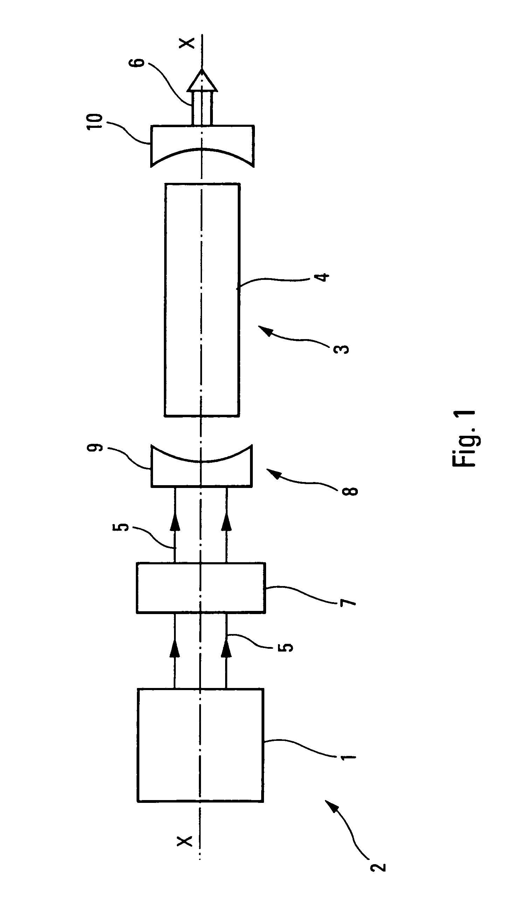

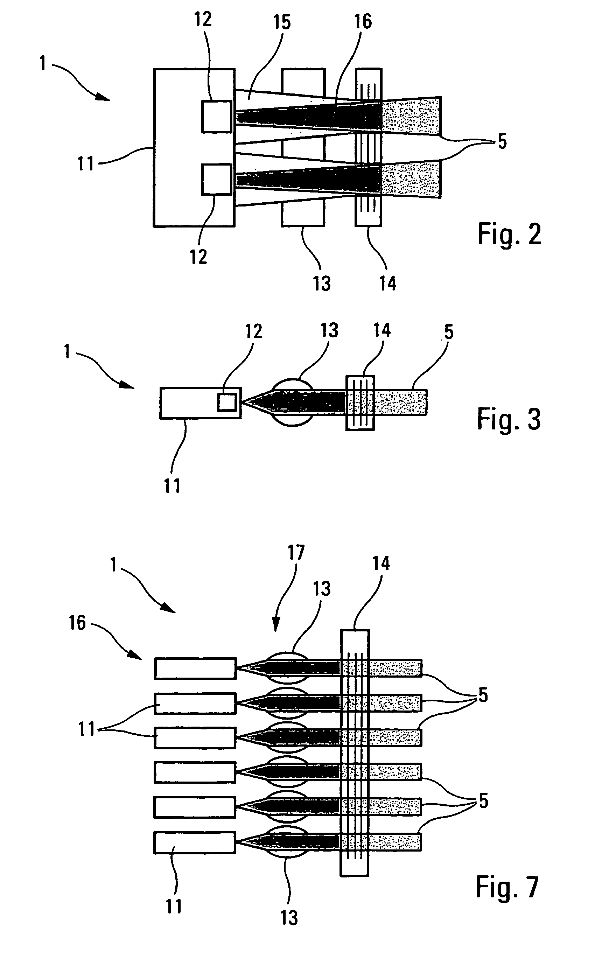

Le système de pompage 1 conforme à l'invention et représenté schématiquement sur les figures 2 et 3 peut être intégré dans une source laser 2 telle que représentée à titre d'exemple sur la figure 1.

Ladite source laser 2 comporte, de façon usuelle :

- un élément actif 3 comprenant un barreau allongé 4 qui comporte une matrice dopée susceptible d'absorber un faisceau de pompage 5, pour amplifier au moins un rayonnement laser 6 se propageant longitudinalement selon un axe X-X ;
- ledit système du pompage 1 précisé ci-dessous, qui est susceptible d'émettre au moins un faisceau de pompage 5 ;
- un système optique de transport 7 usuel, pour diriger le faisceau de pompage 5 émis par ledit système de pompage 1 dans ledit élément actif 3 de manière à obtenir un pompage longitudinal ; et
- une cavité optique 8 usuelle, d'axe X-X, comprenant notamment un miroir 9 réfléchissant et un miroir 10 partiellement transparent, qui sont placés en regard l'un de l'autre. Cette cavité optique 8 confère au rayonnement laser 6 obtenu par l'amplification laser et émis à travers ledit miroir 10 selon l'axe X-X, ses caractéristiques de directivité et de géométrie.

En outre, ledit système de pompage 1 comporte au moins une diode laser de pompage 12 qui est par exemple montée, de façon usuelle, sur une barrette 11 et qui est susceptible d'émettre le faisceau de pompage 5, ainsi qu'un moyen de collimation usuel 13, par exemple une lentille, qui est associé à ladite diode de pompage 12, comme représenté sur les figures 2 et 3.

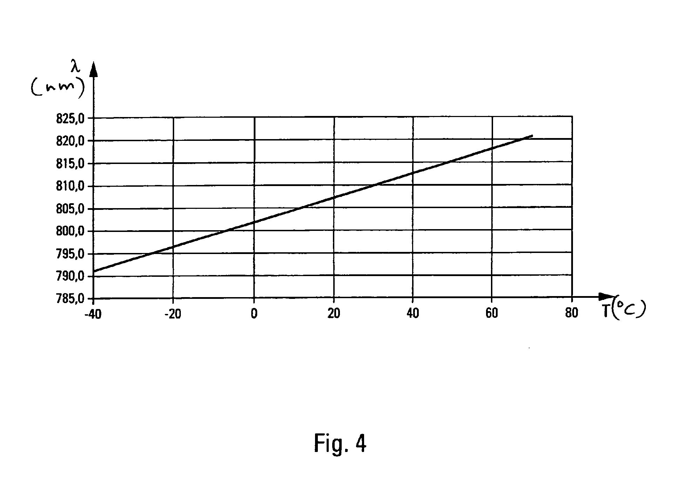

On sait qu'une telle diode de pompage 12, de type laser, engendre un faisceau de pompage 5, dont la longueur d'onde λ varie avec la température T, comme représenté sur la figure 4 où λ est exprimé en nanomètre et T en degrés Celsius. Généralement, les diodes laser présentent un spectre d'émission, de quelques nanomètres de large, qui se décale de 0,25 à 0,3 nanomètre par degré Celsius, lorsque l'on fait varier la température T.

La présente invention a pour objet de remédier à cet inconvénient de manière à obtenir un faisceau de pompage 5 présentant une plage d'insensibilité thermique très étendue, par exemple entre -40°C et au moins +70°C.

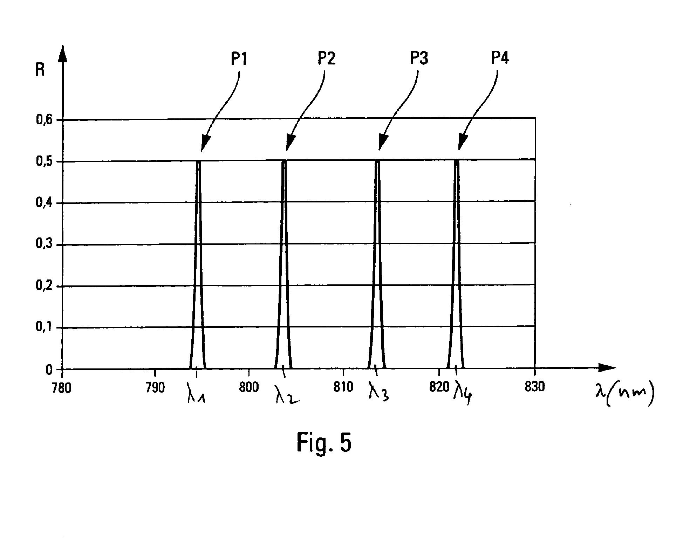

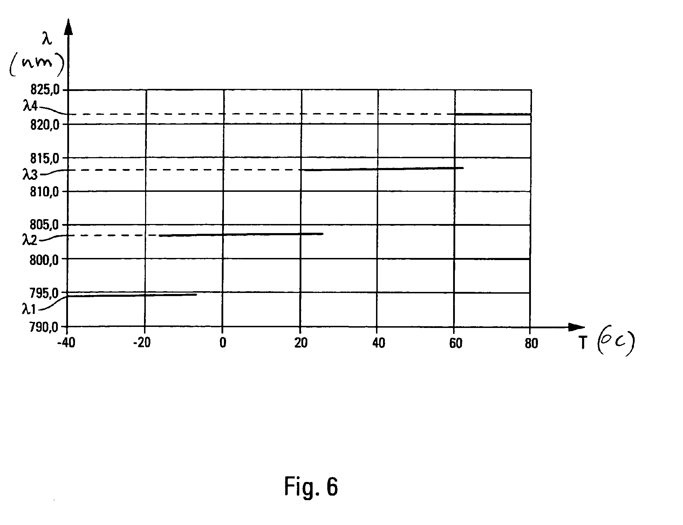

Pour ce faire, selon l'invention, ledit système de pompage 1 comporte, de plus, un miroir sélectif 14 qui est formé, comme précisé ci-dessous, de manière à comprendre une pluralité de pics de réflectivité spectrale P1, P2, P3, P4 (figure 5) pour accrocher le fonctionnement de la ou des diodes laser de pompage 12 sur au moins l'un de ces pics P1 à P4 lors d'une variation de température T de ladite diode laser de pompage 12 de sorte que le système de pompage 1 émette un faisceau de pompage 5, dont la longueur d'onde λ varie par paliers, successivement suivant une pluralité de longueurs d'onde prédéterminée λ1, λ2, λ3, λ4 comme représenté sur la figure 6, lors de la variation de température T.

De préférence, lesdites longueurs d'onde prédéterminées λ1, λ2, λ3 et λ4 correspondent à des longueurs d'onde, pour lesquelles le coefficient d'absorption α de l'élément actif 3 qui est associé audit système de pompage 1 est supérieur à chaque fois à une valeur prédéterminée (élevée), par exemple $1,7 \ cm^{-1}$ en pompage longitudinal ou bien par exemple $5 \ cm^{-1}$ en pompage transverse, c'est-à-dire pour lesquelles on obtient une absorption importante du faisceau de pompage 5 par ledit élément actif 3 associé.

Ainsi, grâce aux caractéristiques conformes à l'invention dudit miroir sélectif 14, lorsque la température T varie, la longueur d'onde du faisceau de pompage 5 émis par ledit système de pompage 1 ne varie pas de façon continue comme dans l'état de la technique représentée sur la figure 4, mais elle varie par paliers en prenant à chaque fois une ou plusieurs valeurs λ1 à λ4 de longueur d'onde (figure 6) qui permettent chacune une bonne absorption dudit faisceau de pompage 5 par l'élément actif 3, c'est-à-dire un pompage particulièrement efficace. On obtient donc un faisceau de pompage 5 présentant une plage d'insensibilité thermique particulièrement étendue, de -40°C à environ +80°C dans l'exemple représenté sur la figure 6.

De préférence, lesdites longueurs d'onde prédéterminées λ1 à λ4 correspondent à des longueurs d'onde pour lesquelles ledit coefficient d'absorption α fait partie à chaque fois d'un même domaine de coefficients d'absorption, relativement limité, par exemple $[1,7 \ cm^{-1} \ ; \ 2,2 \ cm^{-1}]$. Ainsi, on obtient un pompage relativement uniforme dans le milieu actif, quelle que soit la température T.

Ledit miroir sélectif 14 présente donc une certaine réflectivité R, auxdits pics de réflectivité spectrale P1 à P4, qui est fixée lors de la conception et de la réalisation de ce miroir sélectif 14. Placé devant une barrette 11 collimatée, ce miroir sélectif 14 va agir comme un filtre en réinjectant par réflexion dans le milieu à gain qu'est la barrette 11, un rayonnement 15 qui est affiné spectralement, comme représenté sur la figure 2. Le miroir sélectif 14 impose ainsi par cette rétroaction une contrainte supplémentaire aux diodes laser 1 2 de la barrette 11 de manière à accrocher le fonctionnement desdites diodes laser 1 2 à chaque fois sur au moins l'un de ces pics P1 à P4 de réflectivité spectrale, ce qui permet d'obtenir finalement le décalage spectral du faisceau de pompage 5 représenté sur la figure 6, en fonction de la température T.

L'espace spectral entre chacun des pics P1 à P4 de réflectivité spectrale doit être inférieur à l'amplitude spectrale totale de contrôle du miroir 14 dans la configuration (de semi-conducteurs, de collimation et de miroir) retenue.

Ledit miroir sélectif 14 peut être réalisé de différentes manières.

Dans un premier mode de réalisation, il est réalisé à partir de réseaux de Bragg, du type précité, qui sont formés dans au moins un milieu solide. Il est possible d'inscrire plusieurs réseaux correspondant chacun à une longueur d'onde dans un milieu solide. Ces réseaux de Bragg peuvent s'interpénétrer ou bien être situés à des profondeurs différentes dans le substrat, ou bien encore être inscrits dans un substrat disjoint en étant disposés l'un derrière l'autre pour reconstituer un miroir multi-raies. De plus, la position de chaque raie de réflexion (ou pic de réflectivité spectrale) peut être choisie indépendamment des autres positions de raie.

Dans un deuxième mode de réalisation, ledit miroir sélectif 14 est réalisé, de façon usuelle, par des dépôts multi-diélectriques sur des substrats.

En outre, dans un troisième mode de réalisation, ledit miroir sélectif 14 est réalisé de façon usuelle, en utilisant des interférences entre deux surfaces réfléchissantes engendrant un effet Fabry-Pérot. Dans ce cas, toutefois, la position de chaque raie de réflexion est interdépendante des autres, puisque l'on peut uniquement modifier la position d'une raie de réflexion indépendamment, ainsi que l'intervalle spectral libre la séparant des raies de réflexion suivantes.

Par ailleurs, ledit moyen de collimation 13 a pour objet de collimater le rayonnement 16 des diodes 12, au moins suivant leur axe rapide, avant que ce rayonnement 16 atteigne le miroir sélectif 14. En effet, sans collimation, les angles d'incidence des rayons sur le miroir sélectif 14 seraient trop dispersés, à cause de l'angle angulaire d'émission des diodes 12 qui atteint typiquement 10 x 40°.

A titre d'illustration, on présente à présent un système de pompage 1 particulier permettant de pomper longitudinalement avec efficacité un barreau 4 de YAG de longueur L = 12 mm entre -40°C et +70°C.

Pour obtenir une efficacité d'absorption de 90%, il faut que le coefficient d'absorption $\alpha$ atteigne au moins 1,92 cm$^{-1}$. L'absorption Abs vaut dans ce cas :

$$Abs = 1\text{-}exp(\text{-}\alpha.L) = 1\text{-}exp(\text{-}1{,}92 \times 1{,}2 \; \text{cm}) = 0{,}9$$

Par ailleurs, si l'on souhaite obtenir un dépôt de l'énergie de pompage qui reste relativement constant pour chaque palier de longueur d'onde $\lambda$, il faut que cette absorption reste proche de 1,9, soit approximativement entre 1,7 et 2,2 cm$^{-1}$.

On sait que, sur le spectre d'absorption du milieu actif YAG dopé à 1% de néodyme Nd, il existe douze zones de quelques centaines de picomètres chacune vérifiant cette condition. Il s'agit des coordonnées suivantes (en nanomètre) :

{791,9 ; 793,4 ;794,5 ;796,0 ; 798,6 ; 803,6 ; 809,6 ; 811,6 ; 813,5 ; 816,9 ; 817,8 ; 821,6}.

Pour couvrir convenablement la plage thermique considérée (-40°C à +70°C), on sélectionne par exemple quatre coordonnées spectrales $\lambda 1$, $\lambda 2$, $\lambda 3$ et $\lambda 4$ séparées les unes des autres par moins de 10 nm, soit les coordonnées spectrales {794,5 ; 803,6 ; 813,5 ; 821,6} puis on réalise au moins un miroir sélectif 14 à quadruple bande, présentant la réflectivité R représentée sur la figure 5.

Ce miroir sélectif 14 à quadruple bande est positionné devant une barrette 11 qui est collimatée par un moyen de collimation 13 de sorte que l'on obtienne un faisceau de pompage 5 présentant successivement lesdites longueurs d'onde $\lambda 1$, $\lambda 2$, $\lambda 3$, $\lambda 4$ en fonction de la température T, comme représenté sur la figure 6.

Dans le cadre de la présente invention, le système de pompage 1 peut comporter notamment une seule diode laser de pompage 12, une barrette 11 munie d'une pluralité de telles diodes 12 comme cela est représenté sur les figures 2 et 3, ou un ensemble 16 (ou empilement) de barrettes 11 comme représenté sur la figure 7.

Dans ce dernier exemple, on peut également prévoir un ensemble 17 d'une pluralité de moyens de collimation 13.

De plus, dans ce dernier exemple, on peut prévoir :

- un seul miroir 14 pour l'ensemble 16 de barrettes 11 ; ou
- un miroir sélectif 14 pour chaque barrette 11 dudit ensemble 1 6 ; ou
- un miroir sélectif par groupe de plusieurs barrettes 11.

Bien que, dans les exemples décrits ci-dessus, le système de pompage 1 selon l'invention soit associé à une source laser 2 à pompage longitudinal, on comprendra aisément que ce système de pompage peut être mis en oeuvre pour tout autre sorte de pompage, par exemple transverse, semi-transverse ou autre.

**Revendications**

1. Système de pompage pour source laser, ledit système de pompage (1) comportant :

   - au moins une diode de pompage (12) susceptible d'émettre au moins un faisceau de pompage (5), dont la longueur d'onde ($\lambda$) varie avec la température (T) ;
   - au moins un moyen de collimation (13) associé à ladite diode de pompage (12) ; et
   - au moins un miroir sélectif (14) permettant de sélectionner une longueur d'onde de ladite diode de pompage (12),

   **caractérisé en ce que** ledit miroir sélectif (14) est formé de manière à comprendre une pluralité de pics de réflectivité spectrale (P1 à P4) et qu'il est placé devant une barrette (11) qui est munie de au moins la diode de pompage (12), associée au moyen de collimation (13) de manière à réinjecter dans la barrette (11) par réflexion, sur ledit miroir sélectif, un rayonnement (15) qui est affiné spectralement.

**2.** Système de pompage selon la revendication 1,
**caractérisé en ce que** ledit miroir sélectif (14) est formé de sorte que les longueurs d'onde (λ1 à λ4) qui sont émises par paliers par ledit système de pompage (1) correspondent à des longueurs d'onde particulières.

**3.** Système selon l'une quelconque des revendications 1 et 2,
**caractérisé en ce que** ledit miroir sélectif (14) comporte des réseaux de Bragg formés dans au moins un milieu solide.

**4.** Système selon l'une quelconque des revendications 1 et 2,
**caractérisé en ce que** ledit miroir sélectif (14) comporte des dépôts multi-diélectriques réalisés sur des substrats.

**5.** Système selon l'une quelconque des revendications 1 et 2,
**caractérisé en ce que** ledit miroir sélectif (14) comporte des surfaces réfléchissantes qui sont agencées de sorte que des interférences entre deux surfaces réfléchissantes sont susceptibles d'engendrer un effet Fabry-Pérot.

**6.** Source laser comportant :

- un élément actif (3) qui comporte une matrice dopée susceptible d'absorber au moins un faisceau de pompage (5) pour amplifier au moins un rayonnement laser (6) ;
- un système de pompage (1) susceptible d'émettre au moins un faisceau de pompage (5) ;
- un système optique de transport (7) pour diriger le faisceau de pompage (5) émis par ledit système de pompage (1) dans ledit élément actif (3) de manière à obtenir le pompage dudit élément actif ; et
- une cavité optique (8) permettant d'extraire ledit rayonnement laser (6),

**caractérisée en ce que** ledit système de pompage (1) est du type de celui spécifié sous l'une quelconque des revendications 1 à 5.

**7.** Source laser selon la revendication 6,
**caractérisé en ce que** ledit miroir sélectif (14) est formé de sorte que les longueurs d'onde (λ1 à λ4) qui sont émises par paliers par ledit système de pompage (1) correspondent à des longueurs d'onde, pour lesquelles un coefficient d'absorption dudit élément actif (3) est supérieur à chaque fois à une valeur prédéterminée.


**Claims**

**1.** A pumping system for a laser source, said pumping system (1) comprising:

- at least one pump diode (12) capable of emitting at least one pump beam (5), the wavelength (λ) of which varies with temperature (T) ;
- at least one collimation means (13) associated with said pump diode (12) ; and
- at least one selective mirror (14) for selecting one wavelength of said pump diode (12),

**characterized in that** said selective mirror (14) is formed so as to comprise a plurality of spectral reflectivity peaks (P1 to P4) and **in that** it is placed in front of a strip (11) that comprises at least said pump diode (12), associated with the collimation means (13) such that a radiation (15) that is spectrally refined is reinjected in the strip (11), after reflection on said selective mirror.

**2.** The pumping system as claimed in claim 1,
**characterized in that** said selective mirror (14) is formed in such a way that said predetermined wavelengths (λ1 to λ4) correspond to particular wavelengths.

**3.** The system as claimed in one of claims 1 and 2,
**characterized in that** said selective mirror (14) comprises Bragg gratings formed in at least one solid medium.

**4.** The system as claimed in one of claims 1 and 2,
**characterized in that** said selective mirror (14) comprises dielectric multilayers deposited on substrates.

**5.** The system as claimed in one of claims 1 and 2,
**characterized in that** said selective mirror (14) comprises reflecting surfaces that are arranged such that interference between two reflecting surfaces are able to generate a Fabry-Pérot effect.

6. A laser source comprising:

- an active element (3) comprising a doped matrix capable of absorbing at least one pump beam (5) in order to amplify at least one beam of laser radiation (6) ;
- a pumping system (1) capable of emitting at least one pump beam (5) ;
- an optical transport system (7) for directing the pump beam (5) emitted by said pumping system (1) into said active element (3) so as to pump said active element; and
- an optical cavity (8) for extracting said laser radiation (6),

**characterized in that** said pumping system (1) is of the type of that specified under any one of claims 1 to 5.

7. The laser source as claimed in claim 6,
**characterized in that** said selective mirror (14) is formed in such a way that the wavelengths ($\lambda$1 to $\lambda$4) which are emitted in steps by said pumping system (1) correspond to wavelengths for which an absorption coefficient of said active element (3) is each time greater than a predetermined value.

**Patentansprüche**

1. Pumpsystem für eine Laserquelle, wobei das Pumpsystem (1) umfasst:

- mindestens eine Pumpdiode (12), die geeignet ist, mindestens ein Pumpbündel (5) auszusenden, dessen Wellenlänge ($\lambda$) mit der Temperatur (T) variiert;
- mindestens ein Kollimationsmittel (13), das der Pumpdiode (12) zugeordnet ist; und
- mindestens einen selektiven Spiegel (14), der es ermöglicht, eine Wellenlänge der Pumpdiode (12) auszuwählen,

**dadurch gekennzeichnet, dass** der selektive Spiegel (14) derart gebildet ist, dass er eine Vielzahl von spektralen Reflexionsgrad-Peaks (P1 bis P4) umfasst und dass er vor einer Leiste (11) angeordnet ist, die mit der mindestens einen Pumpdiode (12) versehen ist, die dem Kollimationsmittel (13) derart zugeordnet ist, dass durch Reflexion an dem selektiven Spiegel eine Strahlung (15), die spektral verfeinert ist, in die Leiste (11) wiedereingespeist wird.

2. Pumpsystem nach Anspruch 1,
**dadurch gekennzeichnet, dass** der selektive Spiegel (14) derart ausgebildet ist, dass die Wellenlängen ($\lambda$1 bis $\lambda$4), die in Stufen durch das Pumpsystem (1) ausgesendet werden, bestimmten Wellenlängen entsprechen.

3. Pumpsystem nach einem der Ansprüche 1 und 2,
**dadurch gekennzeichnet, dass** der selektive Spiegel (14) Bragg-Gitter umfasst, die in mindestens einem festen Medium gebildet sind.

4. Pumpsystem nach einem der Ansprüche 1 und 2,
**dadurch gekennzeichnet, dass** der selektive Spiegel (14) mehrfache dielektrische Schichten umfasst, die auf Substraten gebildet sind.

5. Pumpsystem nach einem der Ansprüche 1 und 2,
**dadurch gekennzeichnet, dass** der selektive Spiegel (14) reflektierende Oberflächen umfasst, die derart angeordnet sind, dass Interferenzen zwischen zwei reflektierenden Oberflächen geeignet sind, einen Fabry-Pérot-Effekt zu erzeugen.

6. Laserquelle, umfassend:

- ein aktives Element (3), das eine dotierte Matrix aufweist, die geeignet ist, mindestens ein Pumpbündel (5) zu absorbieren, um mindestens eine Laserstrahlung (6) zu verstärken;
- ein Pumpsystem (1), das geeignet ist, mindestens ein Pumpbündel (5) auszusenden;
- ein optisches Transportsystem (7), um das vom Pumpsystem (1) ausgesendete Pumpbündel (5) in das aktive Element (3) zu leiten, um das Pumpen des aktiven Elements zu erzielen; und

- einen optischen Resonator (8), der es ermöglicht, die Laserstrahlung (6) zu extrahieren,

**dadurch gekennzeichnet, dass** das Pumpsystem (1) von dem Typ ist, der unter einem der Ansprüche 1 bis 5 spezifiziert ist.

7. Laserquelle nach Anspruch 6,
   **dadurch gekennzeichnet, dass** der selektive Spiegel (14) derart ausgebildet ist, dass die Wellenlängen ($\lambda$1 bis $\lambda$4), die in Stufen durch das Pumpsystem (1) ausgesendet werden, Wellenlängen entsprechen, bei denen ein Absorptionskoeffizient des aktiven Elements (3) jeweils höher ist als ein vorbestimmter Wert.

Fig. 1

EP 1 717 915 B1

Fig. 2

Fig. 3

Fig. 7

Fig. 4

Fig. 5

Fig. 6

**RÉFÉRENCES CITÉES DANS LA DESCRIPTION**

**Documents brevets cités dans la description**

- FR 2803697

- US 20050018743 A